# EUROPEAN PATENT SPECIFICATION

(11) **EP 2 074 668 B1**
(45) Date of publication and mention of the grant of the patent: **28.02.2018**
(21) Application number: 07818838.0
(22) Date of filing: 09.10.2007
(51) Int. Cl.: H01L 33/50, H01L 33/56

(54) **PHOSPHOR-CONVERTED LIGHT EMITTING DIODE**
LEUCHTSTOFFUMGESETZTE LEUCHTDIODE
DIODE ELECTROLUMINESCENTE A CONVERSION PAR PHOSPHORE

(30) Priority: 10.10.2006 EP 06021279
(43) Date of publication of application: 01.07.2009
(73) Proprietor: Tridonic Jennersdorf GmbH, 8380 Jennersdorf (AT)
(72) Inventor: OBERLEITNER, Wolfgang, A-1030 Wien (AT); KAWAGUCHI, Hiroaki, A-8280 Fürstenfeld (AT)
(74) Representative: Rupp, Christian
(86) International application number: PCT/EP2007/008765
(87) International publication number: WO 2008/043519

(56) References cited:
- EP-A1- 0 936 682
- EP-A1- 1 357 610
- WO-A-2005/119797
- WO-A1-2007/025516
- WO-A2-2005/067524
- JP-A- 2005 093 896
- US-A1- 2002 043 926
- US-A1- 2003 132 701
- US-A1- 2003 168 669
- US-A1- 2006 073 625

## Description

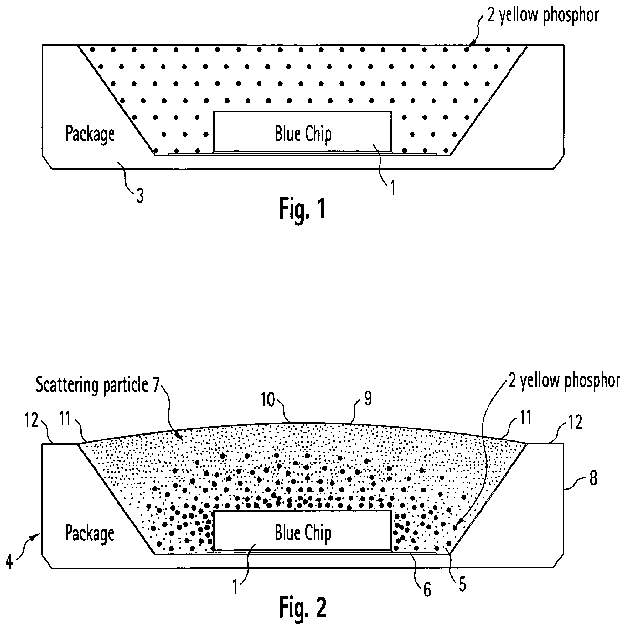

The invention relates to so-called pc-LEDs (phosphor-converted light-emitting diodes), i.e. LEDs in which an emitted spectrum is converted by a so-called phosphor such that a mix of the original spectrum and the converted spectrum is emitted from the pc-LED.
An example of a known LED device is shown in Figure 1 and contains a blue chip 1 and wavelength converting elements 2 (hence also called colour conversion layers or CCL). Such devices usually consist of a blue or UV chip inside a cavity and a colour conversion layer, which converts essentially all or part of the photons from the chip into photons of higher wavelength. The wavelength converting elements may contain one or more inorganic phosphors absorbing part of the light from the chip and re-emitting it, usually isotropically, in the yellow, green, orange and/or red.
The phosphors are suspended in a transparent matrix material, e.g. silicone, which may contain additives such as viscosity modifiers, scattering particles etc. Examples for widely used phosphors are YAG:Ce and BOSE. Colour uniformity and optical efficiency (lm/W) are important parameters for LEDs, which in many cases cannot be changed independently, i.e. the optimisation of colour uniformity entails a decrease in efficiency and vice versa.

For instance, if the phosphor layer is directly surrounding the chip, efficiency usually decreases due to back-reflection into and re-absorption by, the chip. On the other hand, CCLs located near the chip in many cases lead to enhanced colour uniformity. However, colour uniformity can be increased almost without sacrificing efficiency by optimisation of the location of the phosphor relative to the chip and surface of the package 3 as well as by use of multiple layer designs (several colour converting layers of different phosphor concentration and/or alternating converting and non-converting layers with flat/shaped surfaces/interfaces. Shaped surfaces/interfaces of silicone or of the colour converting elements are used in a number of patent applications, for instance in JP2005-93896, US2006/0073625, etc., to increase colour uniformity and/or efficiency.

Achieving high colour uniformity practically without sacrificing efficiency has been the main target of this invention.

Contrary to LEDs where the light emitted from the chip is either converted by the phosphor completely and/or where excess light from the chip must be removed for safety reasons (e.g. green and white LEDs using UV-chips), colour variance (also referred to as the halo-effect) is one of the severe problems of those types of pc-LEDs where the colour conversion layer converts only part of the light from the chip into light of higher wavelength. The different radiation pattern of the chip light and the converted light plays a crucial role in colour variance. The chip light that is not converted, though it may be scattered, reflected or otherwise deviated from its original direction, still has a more narrow radiation pattern than the converted light, which is emitted from the phosphor isotropically. Therefore, the light in the centre of the light-cone has a blue shift, while the light in the boundaries of the light-cone is red-shifted, i.e. there is a bluish centre surrounded by a yellow ring. One way out could be a high concentration of scattering particles (oxides, sulphates of Al, Ti, Ba, etc.), but the use of scattering particles only without any other appropriate measures, while yielding high colour uniformity, leads to a considerable decrease in optical efficiency.

EP 1 357 610 A1 teaches a LED comprising a LED chip having a light emitting layer made of a nitride compound semiconductor and a light transmitting resin that includes a fluorescent material which absorbs at least a part of light emitted by the LED chip and emits light of a different wavelength. The fluorescent material includes fluorescent particles of small particle size and fluorescent particles of large particle size, the fluorescent particles of large particle size being distributed in the vicinity of the LED chip in the light transmitting resin to form a wavelength converting layer. The fluorescent particles of small particles size are distributed on the outside of the wavelength converting layer in the light transmitting resin.

The size distribution according to EP 1 357 610 A1 is illustrated in figure 7. One can easily see that the particle size distribution shows two peaks, i.e. a first peak in a very small particle size and a second peak at a big particle size. Within the two peaks there are essentially no particles. Therefore, when sedimenting, practically all of the big particles will sedimentate and be located in the surroundings of the LED chip only, while the speed of sedimentation of particles of the small fraction will be so small that it can essentially be neglected.
US 2006/065906 A1 teaches a method for manufacturing a semiconductor light emitting device. When forming a wavelength conversion layer, a first resin with little or no wavelength conversion material is filled inside a cavity such that the light emitting element surface is slightly exposed and a surface of a first resin is formed in a bole shape. Then, a second resin with wavelength conversion material contained therein can be filled inside the cavity over the bole-shaped first resin. These resins can be heated to be hardened. During heating the viscosities of the resins are reduced to cause the wavelength conversion material to migrate and deposit around the light emitting element.
Other semiconductor light-emitting devices are disclosed in US 2002/043926 A1, WO 2005/067524 A2, EP 0 936 682 A1, and WO 2007/025516 A1.
It is the object of the present invention to propose a technique for improving the colour uniformity of LEDs.

This object is achieved by means of the features of independent claim 1 The dependent claims 2-17 develop further the central idea of the invention.

According to the invention, a semiconductor light-emitting device comprises a semiconductor light-emitting chip that emits light of a first peak wavelength in the blue wavelength range. All
layers above the semiconductor light-emitting chip comprise a transparent silicone matrix material.

At least two adjacent layers are provided, wherein at least the top layer contains one or more wavelength-converting substances dispersed in the matrix material, the concentration of the one or more wavelength-converting substances continuously increasing in a vertical direction towards the base surface of the semiconductor light-emitting chip. At least one of the at least two adjacent layers can contain viscosity-modifying materials. The at least two adjacent layers differ in at least one of the following parameters: phosphor concentration, phosphor composition, and scattering particle concentration.

The first layer has a curved top surface and optionally contains one or more wavelength-converting substances. The first layer can contain scattering particles. The second layer contains one or more wavelength-converting substances. The second layer contains scattering particles.

The top surface of the second layer can be flat or curved.

Optionally a third layer is placed on top of the second layer.

The third layer may contain one or more wavelength-converting substances and/or scattering particles.

The third layer may have a curved top surface.

According to another aspect of the invention, the first layer covers the upper surface and the side walls of the semiconductor light-emitting chip as a coating and contains one or more wavelength-converting substances. The second layer optionally surrounds the first layer and has a curved top surface. A third layer can be placed on top of the second layer. Preferably the surfaces of the second layer and/or the third layer are curved.

The third layer can contain one or more wavelength-converting substances. At least one layer of the first and the third layer may also contain scattering particles.

In the following a preferred embodiment of the invention will be explained in order to illustrate further feature, objects and advantages of the present invention when taken in conjunction with the figures of the enclosed drawings.
Figure 1 shows a LED device according to the prior art,
Figure 2 shows another LED device, not forming part of the invention,
Figure 3 shows an embodiment of the invention,
Figure 4 shows another LED device, not forming part of the invention,
Figure 5 shows another LED device, not forming part of the invention,
Figure 6 shows another LED device, not forming part of the invention,
Figure 7 shows the phosphor particle size distribution of EP 1 357 610 A1, and
Figure 8 shows the one-peak size distribution of the phosphor particles according to the present invention.

The subject of the present invention encompasses the aspects of using (1) a process of selective sedimentation of phosphor particles optionally in combination with (2) shaped surfaces/interfaces and (3) scattering particles. The aspect can be combined in any order.

The invention comprises the following aspects:
- Above the LED chip there are at least two adjacent layers, all of which comprise a transparent silicone matrix material,
- at least one layer may contain an additive such as e.g. a viscosity modifier,
- at least the second layer contains one or more wavelength-converting substances ('phosphors') and scattering particles.

In the following examples, ΔCIEx and ΔCIEy are defined as the difference between the maximum and the minimum CIEx and CIEy-values, respectively, measured in an area of hemispherical shape surrounding the front side of the LED. A colour variance of ΔCIEx,y < 0.01 can hardly be perceived by the human eye, and LEDs with such a low colour variance show excellent colour uniformity.

In the following examples, data are given for 6500K devices containing a blue die emitting at about 460nm and a yellow BOSE-based phosphor. However, the invention is in no way limited, but can be applied to other systems as well, including a large range of phosphor materials and concentrations covering the whole white region from 2800-7000K. Though excellent colour uniformity is achieved for 6500K in the following examples, even better results can be achieved for lower colour temperatures due to a higher degree of scattering as a consequence of higher phosphor concentration.

It is to be understood that in all shown examples the package 3 can be made from silicon. Preferably the side walls 16 of the cavity housing the LED chip can be metallised.

### Reference Device 1 (Figure 2)

The LED device 8 comprises a casing 4 with a concave-shaped cavity 5, a light-emitting element (a die) 1 located at the bottom 6 of the cavity 5, a resin for filling the cavity 5, and electrodes and electrical wiring for power supply to the device, which are not shown. The LED device 8 is filled with a colour conversion layer (CCL) containing the phosphor 2, small scattering particles 7 preferably in the sub-micron range, and small amounts of additives. After dispensing, the LED device 8 is submitted to a temperature treatment. The temperature is chosen in a way to achieve a compromise between minimum viscosity for efficient deposition of the phosphor and a low cure rate; the matrix material should not cure to any considerable extent before deposition of the phosphor. After deposition, the temperature is raised to achieve complete cure of the colour conversion layer. The major effects of this treatment are as follows:
- Due to the much larger particle size of the phosphor particles 2 compared to the scattering particles 7, the phosphor deposits, while there is no considerable deposition of the scattering particles 7.
- Furthermore, due to the particle size distribution of the phosphor 2, smaller phosphor particles do not sediment as quickly as bigger ones, which results in an accumulation of big phosphor particles 2 near the chip 1. The average size of the phosphor particles 2 is the bigger the closer to the chip 1.

ΔCIEx,y-values of about 0.005 can be achieved in such a configuration (In a standard device as depicted in Figure 1, ΔCIEx,y is about 0.015-0.030 for a yellow BOSE phosphor).

The useful lumen loss due to scattering effects, increased back-reflection into the chip 1 and re-absorption by the chip is <5% compared to the standard device. In devices without scattering particles, colour uniformity decreases, but is still better than in the known device as depicted in figure 1.

In all further examples, ΔCIEx,y-values of below 0.01 are achieved.

Preferably in the device of Figure 2 the top surface 9 of the filling extends in a curved shape at least in its centre 10 beyond the level of the adjacent top surface 12 of the package 3. The edge portion 11 of the filling flushes with the level of the top surface 12 of the package 3.

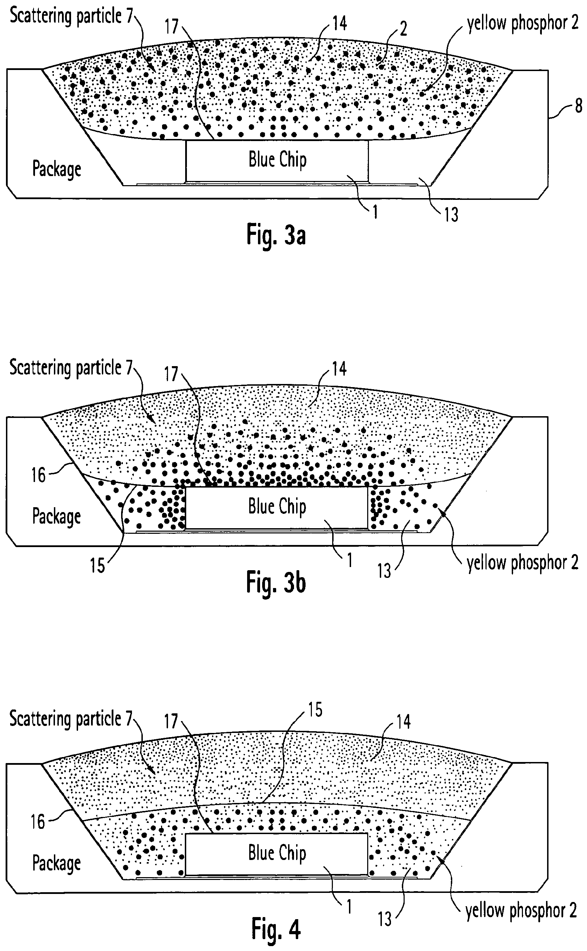

### Embodiment Device (Figure 3)

Into a device similar to the one described above, the lower portion 13 of the cavity is filled with clear silicone 14. The upper portion 14 is subsequently filled with colour conversion layer containing the phosphor 2, scattering particles 7 and a small amount of additives (Figure 3a). After dispensing, the LED device 8 is submitted to a temperature treatment as described above. The phosphor 2 sediments to the lower portion of the cavity (Figure 3b), while scattering particles 7 stay in the upper portion 14 of the device.

The particle distribution is similar to that in Figure 1, but there is less phosphor at the boundaries than in the centre which has a positive effect on colour uniformity.

Again, the top surface 9 of the filling extends in a curved shape at least in its centre 10 beyond the level of the top surface 12 of the package 3. The edge portion 11 of the filling flushes with the level of the top surface 12 of the package 3.

The interface 15 between the upper portion 14 and the lower portion 13 of the filling of the cavity is set such it essentially flushes with the level of the top surface of the chip 1. It is slightly raised towards the edges, i.e. where it joins the slanted side walls 16 of the cavity.

### Reference Device 3 (Figure 4)

The lower part of the LED is filled with colour conversion layer with or without scattering particles. There is no temperature treatment and no sedimentation of the phosphor. The upper part of the device is filled with a scattering particle layer. The viscosity of both layers is higher than in examples 1 and 2 so that both the interface 14 between the two portions 13, 14 and the top surface 12 are slightly curved upwards. This curvature can increase light output and enhance colour uniformity.

Preferably the level of the interface 14, both in its centre and edge portions is set higher than the level of the top surface 17 of the chip 1.

Again, the top surface 9 of the filling extends in a curved shape at least in its centre 10 beyond the level of the top surface 12 of the package 3. The edge portion 11 of the filling flushes with the level of the top surface 12 of the package 3.

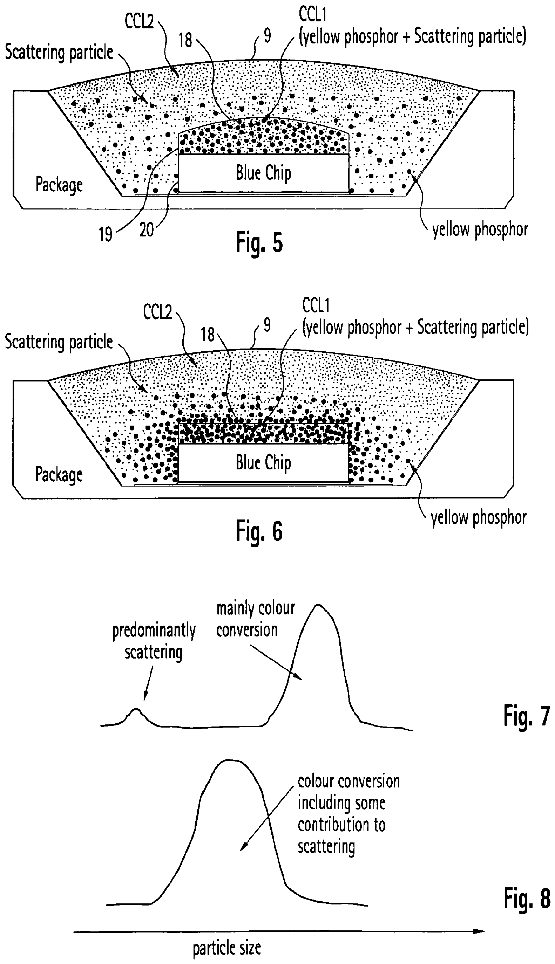

### Reference Device 4 (Figure 5)

A pre-fabricated colour conversion element (e.g. a foil) CCL1, comprising phosphor and scattering particles, is placed directly onto the chip 1. The top surface 18 of the pre-fabricated colour conversion element CCL1 can be curved upwards.

The side walls 19 of the pre-fabricated colour conversion element (e.g. a foil) CCL1 can flush with the side walls 20 of the chip 1. Thus the CCL1, when seen from above, can have the same contours as the chip 1.

The remaining cavity is filled with a second colour conversion layer CCL2 with lower phosphor concentration. The phosphor concentration is 0 ≤ CCL2 < CCL1. Both the surface of the foil and that of CCL2 can have different degrees of curvature depending on the package geometry.

The curvature increases light output and enhances colour uniformity.

Again, the top surface 9 of the filling extends in a curved shape at least in its centre 10 beyond the level of the top surface 12 of the package 3. The edge portion 11 of the filling flushes with the level of the top surface 12 of the package 3.

### Reference Device 5 (Figure 6)

A pre-fabricated colour conversion foil is placed directly onto the chip (CCL1). The top surface 18 of the pre-fabricated colour conversion element (e.g. a foil) CCL1 can be flat.

The side walls 19 of the pre-fabricated colour conversion element (e.g. a foil) CCL1 can flush with the side walls 20 of the chip 1. Thus the CCL1, when seen from above, can have the same contours as the chip 1.

The remaining cavity is filled with a second colour conversion layer (CCL2) with lower phosphor concentration. The phosphor concentration is 0 ≤ CCL2 < CCL1. After dispensing of CCL2, the device is submitted to temperature treatment as described in Example 1. The phosphor of CCL2 thereby sediments while the distribution of scattering particles in the cavity remains essentially unaltered by the sedimentation process.

Again, the top surface 9 of the filling extends in a curved shape at least in its centre 10 beyond the level of the top surface 12 of the package 3. The edge portion 11 of the filling flushes with the level of the top surface 12 of the package 3.

Figure 8 shows the particle size distribution of the colour conversion particles according to the present invention.

As can be seen from figure 8, this is a "normal" particle size distribution having one peak only. According to the invention, smaller particles will sediment very slowly, while the bigger particles will sediment faster. In view of the continuous particle size distribution of figure 8, this will result in two continuous gradients:
Gradient 1: The average particle size increases continuously from the top to the bottom, and
Gradient 2: The average particle concentration of the colour conversion particles increases continually from the top to the bottom.

In view of the particle size distribution of figure 8, there will only be a low contribution to scattering from the phosphors (colour conversion particles) according to the invention.

Therefore preferably a different material will be used for the scattering.

As can be seen in figures 2 to 6, the scattering particles will preferably be distributed in the silicone matrix in a homogenous manner, i.e. without showing a concentration gradient from the top to the bottom of the chip arrangement.

This is in stark contrast to EP 1 357 610 according to which the small particle fraction of the phosphor (left peak in Fig. 7) contributes mainly to scattering with only minor effects on colour conversion, while the big particle fraction contributes mainly to colour conversion rather than to scattering (right peak in Fig. 7).

## Claims

1. A semiconductor light-emitting device (8), comprising:
a package (3) having a cavity (5),
a semiconductor light-emitting chip (1) located at the bottom of said cavity (5) and that emits light of a first peak wavelength in the blue wavelength range, and
at least two layers (13, 14) filling said cavity (5) and comprising a transparent silicone matrix material,
wherein at least one of said at least two layers (13, 14) contains one or more wavelength-converting substances (2) dispersed in the silicone matrix material and converting the light of the first peak wavelength from said semiconductor light-emitting chip (1) at least partially into light of a second wavelength,
such that a mix of light of the first peak wavelength and second wavelength is emitted from the device,
wherein the concentration of said one or more wavelength converting substances (2) continuously increases in a vertical direction towards the base surface of said semiconductor light-emitting chip (1),
wherein said at least two layers (13, 14) comprise a first layer (13) filling the lower portion of said cavity (5) and has a curved top surface and optionally contains said one or more wavelength-converting substances (2),
wherein said at least two layers (13, 14) comprise a second layer (14) disposed on said curved top surface of said first layer (13) and contains said one or more wavelength-converting substances (2) and scattering particles (7), and
wherein said at least two layers (13, 14) comprise two adjacent layers (13, 14), which differ in at least one of the following parameters: concentration of said one or more wavelength-converting substances (2), composition of said one or more wavelength-converting substances (2), and scattering particle concentration.

2. The semiconductor light-emitting device (8) of Claim 1, wherein the size distribution of said one or more wavelength-converting substances (2) is continuously distributed around a single peak.

3. The semiconductor light-emitting device (8) of Claim 1 or 2, wherein said one or more wavelength-converting substances (2) are distributed in the matrix such that the average particle size of said one or more wavelength-converting substances (2) continuously increases in the vertical direction towards the base surface.

4. The semiconductor light-emitting device (8) of any of the preceding claims, wherein
- said first layer (13) covers the upper surface of said semiconductor light-emitting chip (1), and
- the centre region of the top surface of said first layer (13) is higher vis-à-vis said semiconductor light-emitting chip (1) than the edge portion thereof.

5. The semiconductor light-emitting device (8) of any of the preceding claims, wherein said first layer (13) contains scattering particles (7).

6. The semiconductor light-emitting device (8) of any of the preceding claims, wherein the top surface of said second layer (14) is flat.

7. The semiconductor light-emitting device (8) of any of the preceding claims, wherein the top surface of said second layer (14) is curved.

8. The semiconductor light-emitting device (8) of any of the preceding claims, wherein said at least two layers (13, 14) comprise a third layer placed on top of said second layer (14).

9. The semiconductor light-emitting device (8) of claim 8, wherein said third layer contains said one or more wavelength-converting substances (2) and/or scattering particles (7).

10. The semiconductor light-emitting device (8) of any of the claims 8 or 9, wherein said third layer has a curved top surface.

11. The semiconductor light-emitting device (8) of any of the preceding claims, wherein said package (3) is made from silicon.

12. The semiconductor light-emitting device (8) of claim 11, wherein side walls defining said cavity (5) are metallised.

13. The semiconductor light-emitting device (8) of claim 1,
wherein said first layer (13) covers the upper surface and the sidewalls of said semiconductor light-emitting chip (1) as a coating layer and contains said one or more wavelength-converting substances (2), and
wherein the centre region of the top surface of said first layer (13) is higher vis-à-vis said semiconductor light-emitting chip (1) than the edge portion thereof.

14. The semiconductor light-emitting device (8) of claim 13, wherein said second layer (14) surrounds said first layer (13) and has a curved top surface.

15. The semiconductor light-emitting device (8) of claim 14, wherein said at least two layers (13, 14) comprise a third layer placed on top of said second layer (14).

16. The semiconductor light-emitting device (8) of claim 15, wherein the top surfaces of said the second layer (14) and/or said third layer are curved.

17. The semiconductor light-emitting device (8) of either claim 15 or 16, wherein said third layer contains said one or more wavelength-converting substances (2).

## Patentansprüche

1. Lichtemittierendes Halbleiterbauelement (8), umfassend:
ein Gehäuse (3) mit einer Vertiefung (5),
einen lichtemittierenden Halbleiter-Chip (1), der sich am Boden der Vertiefung (5) befindet und der Licht einer ersten Peak-Wellenlänge im blauen Wellenlängenbereich emittiert, und
mindestens zwei Schichten (13, 14), die die Vertiefung (5) füllen und transparentes Silikonmatrixmaterial umfassen,
wobei mindestens eine der mindestens zwei Schichten (13, 14) eine oder mehrere Wellenlängen wandelnde Substanzen (2) enthält, die in dem Silikonmatrixmaterial verteilt sind und das Licht der ersten Peak-Wellenlänge von dem lichtemittierenden Halbleiter-Chip (1) zumindest teilweise in Licht einer zweiten Wellenlänge wandeln, so dass eine Mischung aus Licht der ersten Peak-Wellenlänge und der zweiten Wellenlänge von dem Bauelement emittiert wird,
wobei die Konzentration der einen oder der mehreren Wellenlängen wandelnden Substanzen (2) in vertikaler Richtung hin zur Basisoberfläche des lichtemittierenden Halbleiter-Chips (1) konstant zunimmt,
wobei die mindestens zwei Schichten (13, 14) eine erste Schicht (13) umfassen, die den unteren Teil der Vertiefung (5) füllt und eine gekrümmte Oberseite aufweist und optional die eine oder die mehreren Wellenlängen wandelnden Substanzen (2) enthält,
wobei die mindestens zwei Schichten (13, 14) eine zweite Schicht (14) umfassen, die auf der gekrümmten Oberseite der ersten Schicht (13) angeordnet ist und die eine oder die mehreren Wellenlängen wandelnden Substanzen (2) und streuende Partikel (7) enthält, und
wobei die mindestens zwei Schichten (13, 14) zwei aneinandergrenzende Schichten (13, 14) umfassen, die sich in mindestens einem der folgenden Parameter unterscheiden: Konzentration der einen oder der mehreren Wellenlängen wandelnden Substanzen (2), Zusammensetzung der einen oder der mehreren Wellenlängen wandelnden Substanzen (2) und Konzentration der streuenden Partikel.

2. Lichtemittierendes Halbleiterbauelement (8) nach Anspruch 1, wobei die Größenverteilung der einen oder der mehreren Wellenlängen wandelnden Substanzen (2) konstant um einen einzelnen Peak herum verteilt ist.

3. Lichtemittierendes Halbleiterbauelement (8) nach Anspruch 1 oder 2, wobei die eine oder die mehreren Wellenlängen wandelnden Substanzen (2) derart in der Matrix verteilt sind, dass die durchschnittliche Partikelgröße der einen oder der mehreren Wellenlängen wandelnden Substanzen (2) in vertikaler Richtung hin zur Basisoberfläche konstant zunimmt.

4. Lichtemittierendes Halbleiterbauelement (8) nach einem der vorhergehenden Ansprüche, wobei
die erste Schicht (13) die obere Oberfläche des lichtemittierenden Halbleiter-Chips (1) bedeckt und
die mittlere Region der Oberseite der ersten Schicht (13) im Vergleich zum lichtemittierenden Halbleiter-Chip (1) höher liegt als ihr Randabschnitt.

5. Lichtemittierendes Halbleiterbauelement (8) nach einem der vorhergehenden Ansprüche, wobei die erste Schicht (13) streuende Partikel (7) enthält.

6. Lichtemittierendes Halbleiterbauelement (8) nach einem der vorhergehenden Ansprüche, wobei die Oberseite der zweiten Schicht (14) eben ist.

7. Lichtemittierendes Halbleiterbauelement (8) nach einem der vorhergehenden Ansprüche, wobei die Oberseite der zweiten Schicht (14) gekrümmt ist.

8. Lichtemittierendes Halbleiterbauelement (8) nach einem der vorhergehenden Ansprüche, wobei die mindestens zwei Schichten (13, 14) eine dritte Schicht umfassen, die auf der zweiten Schicht (14) platziert ist.

9. Lichtemittierendes Halbleiterbauelement (8) nach Anspruch 8, wobei die dritte Schicht eine oder mehrere Wellenlängen wandelnde Substanzen (2) und/oder streuende Partikel (7) enthält.

10. Lichtemittierendes Halbleiterbauelement (8) nach einem der Ansprüche 8 oder 9, wobei die dritte Schicht eine gekrümmte Oberseite aufweist.

11. Lichtemittierendes Halbleiterbauelement (8) nach einem der vorhergehenden Ansprüche, wobei das Gehäuse (3) aus Silicium gefertigt ist.

12. Lichtemittierendes Halbleiterbauelement (8) nach Anspruch 11, wobei die Seitenwände, die die Vertiefung (5) definieren, metallisiert sind.

13. Lichtemittierendes Halbleiterbauelement (8) nach Anspruch 1, wobei die erste Schicht (13) die obere Oberfläche und die Seitenwände des lichtemittierenden Halbleiter-Chips (1) als Überzugsschicht bedeckt und die eine oder die mehreren Wellenlängen wandelnden Substanzen (2) enthält und
wobei
die mittlere Region der Oberseite der ersten Schicht (13) im Vergleich zum lichtemittierenden Halbleiter-Chip (1) höher liegt als ihr Randabschnitt.

14. Lichtemittierendes Halbleiterbauelement (8) nach Anspruch 13, wobei die zweite Schicht (14) die erste Schicht (13) umgibt und eine gekrümmte Oberseite aufweist.

15. Lichtemittierendes Halbleiterbauelement (8) nach Anspruch 14, wobei die mindestens zwei Schichten (13, 14) eine dritte Schicht umfassen, die auf der zweiten Schicht (14) platziert ist.

16. Lichtemittierendes Halbleiterbauelement (8) nach Anspruch 15, wobei die obere Oberfläche der zweiten Schicht (14) und/oder der dritten Schicht gekrümmt ist.

17. Lichtemittierendes Halbleiterbauelement (8) nach Anspruch 15 oder 16, wobei die dritte Schicht die eine oder die mehreren Wellenlängen wandelnden Substanzen (2) enthält.

## Revendications

1. Dispositif émetteur de lumière (8) à semi-conducteur, comprenant :
un ensemble (3) doté d'une cavité (5),
une puce émettrice de lumière (1) à semi-conducteur située au fond de ladite cavité (5) et qui émet de la lumière d'une première longueur d'onde de crête dans la plage de longueur d'onde bleue, et
au moins deux couches (13, 14) remplissant ladite cavité (5) et comprenant un matériau de matrice en silicone transparent,
dans lequel au moins une desdites couches (13, 14) au moins au nombre de deux contient une ou plusieurs substances (2) de conversion de longueur d'onde dispersées dans le matériau de matrice en silicone et convertissant la lumière de la première longueur d'onde de crête en provenance de ladite puce émettrice de lumière (1) à semi-conducteur au moins partiellement en lumière d'une deuxième longueur d'onde,
de telle sorte qu'un mélange de lumière de la première longueur d'onde de crête et de la deuxième longueur d'onde est émis en provenance du dispositif,
dans lequel la concentration de ladite ou desdites substances (2) de conversion de longueur d'onde augmente dans une direction verticale vers la surface de base de ladite puce émettrice de lumière (1) à semi-conducteur,
dans lequel lesdites couches (13, 14) au moins au nombre de deux comprennent une première couche (13) remplissant la portion inférieure de ladite cavité (5) et a une surface de dessus incurvée et contient optionnellement ladite ou lesdites substances (2) de conversion de longueur d'onde,
dans lequel lesdites couches (13, 14) au moins au nombre de deux comprennent une deuxième couche (14) disposée sur ladite surface de dessus incurvée de ladite première couche (13) et contient ladite ou lesdites substances (2) de conversion de longueur d'onde et des particules diffusantes (7), et
dans lequel lesdites couches (13, 14) au moins au nombre de deux comprennent deux couches (13, 14) adjacentes qui diffèrent par au moins l'un des paramètres suivants : concentration de ladite ou desdites substances (2) de conversion de longueur d'onde, composition de ladite ou desdites substances (2) de conversion de longueur d'onde, et concentration des particules diffusantes.

2. Dispositif émetteur de lumière (8) à semi-conducteur selon la revendication 1, dans lequel la répartition de dimension de ladite ou desdites substances (2) de conversion de longueur d'onde est répartie de façon continue autour d'une crête unique.

3. Dispositif émetteur de lumière (8) à semi-conducteur selon la revendication 1 ou 2, dans lequel ladite ou lesdites substances (2) de conversion de longueur d'onde sont réparties dans la matrice de telle sorte que la dimension moyenne de particules de ladite ou desdites substances (2) de conversion de longueur d'onde augmente de façon continue dans la direction verticale vers la surface de base.

4. Dispositif émetteur de lumière (8) à semi-conducteur selon l'une quelconque des revendications précédentes, dans lequel
- ladite première couche (13) couvre la surface supérieure de ladite puce émettrice de lumière (1) à semi-conducteur, et
- la région centrale de la surface de dessus de ladite première couche (13) est plus haute par rapport à ladite puce émettrice de lumière (1) à semi-conducteur que sa portion de bord.

5. Dispositif émetteur de lumière (8) à semi-conducteur selon l'une quelconque des revendications précédentes, dans lequel ladite première couche (13) contient des particules diffusantes (7) .

6. Dispositif émetteur de lumière (8) à semi-conducteur selon l'une quelconque des revendications précédentes, dans lequel la surface de dessus de ladite deuxième couche (14) est plate.

7. Dispositif émetteur de lumière (8) à semi-conducteur selon l'une quelconque des revendications précédentes, dans lequel la surface de dessus de la deuxième couche (14) est incurvée.

8. Dispositif émetteur de lumière (8) à semi-conducteur selon l'une quelconque des revendications précédentes, dans lequel lesdites couches (13, 14) au moins au nombre de deux comprennent une troisième couche placée au sommet de ladite deuxième couche (14) .

9. Dispositif émetteur de lumière (8) à semi-conducteur selon la revendication 8, dans lequel ladite troisième couche contient ladite ou lesdites substances (2) de conversion de longueur d'onde et/ou des particules diffusantes (7).

10. Dispositif émetteur de lumière (8) à semi-conducteur selon l'une quelconque des revendications 8 ou 9, dans lequel ladite troisième couche a une surface de dessus incurvée.

11. Dispositif émetteur de lumière (8) à semi-conducteur selon l'une quelconque des revendications précédentes, dans lequel ledit ensemble (3) est réalisé en silicium.

12. Dispositif émetteur de lumière (8) à semi-conducteur selon la revendication 11, dans lequel lesdites parois latérales définissant ladite cavité (5) sont métallisées.

13. Dispositif émetteur de lumière (8) à semi-conducteur selon la revendication 1,
dans lequel ladite première couche (13) couvre la surface supérieure et les parois latérales de ladite puce émettrice de lumière (1) à semi-conducteur en tant que couche de revêtement et contient ladite ou lesdites substances (2) de conversion de longueur d'onde, et
dans lequel
la région centrale de la surface de dessus de ladite première couche (13) est plus haute par rapport à ladite puce émettrice de lumière (1) à semi-conducteur que sa portion de bord.

14. Dispositif émetteur de lumière (8) à semi-conducteur selon la revendication 13, dans lequel ladite deuxième couche (14) entoure ladite première couche (13) et a une surface de dessus incurvée.

15. Dispositif émetteur de lumière (8) à semi-conducteur selon la revendication 14, dans lequel lesdites couches (13, 14) au moins au nombre de deux comprennent une troisième couche placée au sommet de ladite deuxième couche (14).

16. Dispositif émetteur de lumière (8) à semi-conducteur selon la revendication 15, dans lequel les surfaces de dessus de ladite deuxième couche (14) et/ou de ladite troisième couche sont incurvées.

17. Dispositif émetteur de lumière (8) à semi-conducteur selon la revendication 15 ou 16, dans lequel ladite troisième couche contient ladite ou lesdites substances (2) de conversion de longueur d'onde.
